# EUROPEAN PATENT APPLICATION

(11) **EP 4 592 693 A1**
(43) Date of publication of application: **30.07.2025**
(21) Application number: 22963164.3
(22) Date of filing: 28.10.2022
(51) Int. Cl.: G01R 31/34

(54) **FAULT DIAGNOSIS METHOD AND APPARATUS FOR MOTOR**

(71) Applicant: Siemens Aktiengesellschaft, 80333 München (DE)
(72) Inventor: NIU, Zhu, Beijing 100600 (CN); ZHANG, Peng, Beijing 102218 (CN); FAN, Shunjie, Beijing 100096 (CN); JIE, Ming, Beijing 100102 (CN); ZHANG, Bin, Beijing 100029 (CN)
(74) Representative: Isarpatent
(86) International application number: PCT/CN2022/128324
(87) International publication number: WO 2024/087182

(57) **Abstract**

A fault diagnosis method for a motor, comprising: acquiring a data group of a motor from a motor driver, and uploading the data group to a cloud server or an edge device, the data group comprising multiple motor operating parameters collected at the same moment (110); training an autoencoder on the cloud server or the edge device according to the data group, downloading the trained autoencoder to the motor driver, and performing, at the motor driver, loading at runtime on the autoencoder (120); after the loading at runtime of the autoencoder is completed, identifying fault data in the data group of the motor by using the autoencoder, and uploading the fault data to the cloud server or the edge device (130); and training a fault diagnosis model on the cloud server or the edge device according to the fault data, and performing fault diagnosis on the fault data in the operation of the motor by using the trained fault diagnosis model (140).

## Description

### Technical field

The present invention mainly relates to the field of industrial digitalization, and in particular relates to a fault diagnosis method and apparatus for a motor.

### Background art

Predictive maintenance is used to predict when equipment in service needs to undergo maintenance, which is only performed when definitely required, so predictive maintenance can reduce costs in comparison with daily or periodic maintenance. Predictive maintenance plays a very important role in motor drive systems; the deployment of predictive maintenance functionality in motor drive systems can avoid losses due to production shutdowns, engineers are not required to manually collect and analyse data, and the accuracy of fault diagnosis can be improved.

Conventional predictive maintenance detects signals in drivers and uses signal processing algorithms to extract characteristics, identifies key parameters of a system, and compares the identified key parameters of the system with a preset threshold, issuing a warning to the user before the system develops a fault. Conventional predictive maintenance has very complex algorithms, so a lot of hardware resources are needed for analysis and computation; furthermore, the algorithms are fixed and difficult to upgrade in drivers, and are only able to diagnose a limited range of fault types.

Some new predictive maintenance solutions use machine learning methods to diagnose faults; these methods use labeled data to train neural network models in the cloud or at edges, and use the trained neural network models for fault prediction and classification. In methods of this type, since machine learning requires a lot of hardware resources, the predictive maintenance system is deployed to the cloud or an edge, and the motor driver uploads all data to the cloud or edge to realize the predictive maintenance function. Since the amount of data transmitted is very large, a lot of network bandwidth needs to be occupied, and a major impact will be felt when network conditions are unfavorable. Moreover, a large amount of labeled data is needed when training the neural network model.

### Summary of the invention

To solve the abovementioned technical problem, the present invention provides a fault diagnosis method and apparatus for a motor, to increase the intelligence and reliability of fault diagnosis, while also increasing the speed of modeling, without the need for large amounts of labeled data, thereby increasing the efficiency and accuracy of fault diagnosis.

To achieve the above objective, the present invention proposes a fault diagnosis method for a motor, characterized in that the method comprises: acquiring a dataset of the motor from a motor driver, and uploading the dataset to a cloud server or an edge device, the dataset comprising multiple motor operating parameters collected at the same point in time; training an autoencoder according to the dataset at the cloud server or the edge device, downloading the trained autoencoder to the motor driver, and subjecting the autoencoder to runtime loading at the motor driver; when the autoencoder runtime loading is complete, using the autoencoder to identify fault data in datasets of the motor, and uploading the fault data to the cloud server or the edge device; training a fault diagnosis model according to the fault data at the cloud server or the edge device, and using the trained fault diagnosis model to subject fault data in motor operation to fault diagnosis. Thus, fault data required by the fault diagnosis model can be obtained by means of the autoencoder, which is an unsupervised-learning neural network model, thus solving the problem of insufficient fault data; in the course of operation, the driver only needs to upload fault data rather than all operating data, so network bandwidth consumption is greatly reduced, and dependence on communication conditions is avoided. Moreover, the training and deployment of the autoencoder and the fault diagnosis model all takes place in the cloud or at the edge, with no need to occupy excessive hardware resources of the driver, thus realizing a lightweight predictive maintenance function of the driver.

Optionally, the step of training an autoencoder according to the dataset at the cloud server or the edge device comprises: training the autoencoder under each operating condition of the motor, until a difference between input data and reconstructed data of the autoencoder is less than a threshold under all operating conditions. Thus, the autoencoder is suitable for all operating conditions of the motor, so that the neural network model of the autoencoder is more accurate, thus making fault diagnosis more accurate.

Optionally, the step of training a fault diagnosis model according to the fault data at the cloud server or the edge device comprises: notifying a user of the fault data, receiving a fault label added to the fault data by the user, and training the fault diagnosis model according to the fault data and the data label. Thus, as a result of the user adding a fault label to the fault data, the data of the fault diagnosis model is more precise, making fault diagnosis more accurate. Optionally, the method further comprises: notifying a user of a fault diagnosis result of the fault diagnosis model, receiving user feedback inputted by the user, re-training the fault diagnosis model if the user feedback is that the fault diagnosis result is inaccurate, and re-training the autoencoder if the user feedback is that the fault diagnosis result is non-existent. Thus, the autoencoder and fault diagnosis model are adjusted according to user feedback, further improving the accuracy of the autoencoder and the fault diagnosis model, and thus improving the accuracy of fault diagnosis.

The present invention further proposes a fault diagnosis method for a motor, the fault diagnosis method being performed in a motor driver, and the method comprising: acquiring a dataset of the motor, and uploading the dataset to a cloud server or an edge device, the dataset comprising multiple motor operating parameters collected at the same point in time; downloading an autoencoder from the cloud server or the edge device, and subjecting the autoencoder to runtime loading at the driver, the autoencoder being obtained by training according to the dataset by the cloud server or the edge device; when the autoencoder runtime loading is complete, using the autoencoder to identify fault data in datasets of the motor, and uploading the fault data to the cloud server or the edge device, the fault data being used to train a fault diagnosis model according to the fault data at the cloud server or the edge device, and using the trained fault diagnosis model to subject fault data in motor operation to fault diagnosis.

The present invention further proposes a fault diagnosis apparatus for a motor, the apparatus comprising: a first data processing module, for acquiring a dataset of the motor from a motor driver, and uploading the dataset to a cloud server or an edge device, the dataset comprising multiple motor operating parameters collected at the same point in time; a training module, for training an autoencoder according to the dataset at the cloud server or the edge device, downloading the trained autoencoder to the motor driver, and subjecting the autoencoder to runtime loading at the motor driver; a second data processing module, for using the autoencoder to identify fault data in datasets of the motor when the autoencoder runtime loading is complete, and uploading the fault data to the cloud server or the edge device; a fault diagnosis module, for training a fault diagnosis model according to the fault data at the cloud server or the edge device, and using the trained fault diagnosis model to subject fault data in motor operation to fault diagnosis.

Optionally, the training module training an autoencoder according to the dataset at the cloud server or the edge device comprises: training the autoencoder under each operating condition of the motor, until a difference between input data and reconstructed data of the autoencoder is less than a threshold under all operating conditions.

Optionally, the fault diagnosis module training a fault diagnosis model according to the fault data at the cloud server or the edge device comprises: notifying a user of the fault data, receiving a fault label added to the fault data by the user, and training the fault diagnosis model according to the fault data and the data label.

Optionally, the apparatus further comprises a user feedback module, the user feedback module notifying a user of a fault diagnosis result of the fault diagnosis model, and receiving user feedback inputted by the user, wherein the fault diagnosis model is re-trained if the user feedback is that the fault diagnosis result is inaccurate, and the autoencoder is re-trained if the user feedback is that the fault diagnosis result is non-existent.

The present invention further proposes a fault diagnosis apparatus for a motor, the fault diagnosis apparatus being implemented in a motor driver, the apparatus comprising: a data upload module, for acquiring a dataset of the motor, and uploading the dataset to a cloud server or an edge device, the dataset comprising multiple motor operating parameters collected at the same point in time; a download module, for downloading an autoencoder from the cloud server or the edge device, and subjecting the autoencoder to runtime loading at the driver, the autoencoder being obtained by training according to the dataset by the cloud server or the edge device; a second data upload module, for using the autoencoder to identify fault data in datasets of the motor when the autoencoder runtime loading is complete, and uploading the fault data to the cloud server or the edge device, the fault data being used to train a fault diagnosis model according to the fault data at the cloud server or the edge device, and using the trained fault diagnosis model to subject fault data in motor operation to fault diagnosis.

The present invention further proposes a motor driver, configured to perform the fault diagnosis method described above.

The present invention further proposes an electronic device, comprising a processor, a memory, and instructions stored in the memory, wherein the instructions, when executed by the processor, realize the method described above.

The present invention further proposes a computer-readable storage medium, having stored thereon computer instructions which, when run, perform the method described above.

The present invention further proposes a computer program product, comprising a computer program which, when executed by a processor, implements the method described above.

### Brief description of the drawings

The following drawings are merely intended to illustrate and explain the present invention schematically, without limiting the scope thereof, wherein:
Fig. 1 is a flow chart of a fault diagnosis method according to an embodiment of the present invention.
Fig. 2 is a schematic drawing of an implementation environment of a fault diagnosis method according to an embodiment of the present invention.
Fig. 3 is a schematic drawing of a training process of an autoencoder according to an embodiment of the present invention.
Fig. 4 is a schematic drawing of an application process of an autoencoder according to an embodiment of the present invention.
Fig. 5 is a schematic drawing of a training process of a fault diagnosis model according to an embodiment of the present invention.
Fig. 6 is a schematic drawing of an application process of a fault diagnosis model according to an embodiment of the present invention.
Fig. 7 is a flow chart of a fault diagnosis method according to another embodiment of the present invention.
Fig. 8 is a schematic drawing of a fault diagnosis apparatus according to an embodiment of the present invention.
Fig. 9 is a schematic drawing of a fault diagnosis apparatus according to another embodiment of the present invention.
Fig. 10 is a schematic drawing of an electronic device according to an embodiment of the present invention.

Key to the drawings:
100 fault diagnosis method
110-150 steps
21 motor
22 motor driver
221 data pool
222 proxy
222a autoencoder runtime
222b data upload unit
23 cloud server
231 autoencoder training unit
232 autoencoder download unit
233 fault diagnosis model training unit
234 fault diagnosis model
235 notification unit
236 feedback receiving unit
300 autoencoder training process
301-310 steps
400 autoencoder application process
401-405 steps
500 fault diagnosis model training process
501-505 steps
600 fault diagnosis model application process
601-610 steps
700 fault diagnosis method
710-730 steps
800 fault diagnosis apparatus
810 first data processing module
820 training module
830 second data processing module
840 fault diagnosis module
900 fault diagnosis apparatus
910 first data upload module
920 download module
930 second data upload module
1000 electronic device
1010 processor
1020 memory

### Detailed description of the invention

To provide a clearer understanding of the technical features, objectives and effects of the present invention, particular embodiments of the present invention are now described with reference to the drawings.

Many specific details are expounded in the description below to facilitate full understanding of the present invention, which nevertheless may also be implemented in other ways different from those described here, and is thus not limited by the specific embodiments disclosed below.

As shown in the present application and the claims, unless otherwise explicitly indicated in the context, words such as "a", "one", "a type" and/or "the" do not specifically mean the singular, and may also include the plural. In general, the terms "comprise" and "include" merely indicate that the explicitly identified steps and elements are comprised; these steps and elements do not constitute an exclusive list, and the method or device might also include other steps or elements.

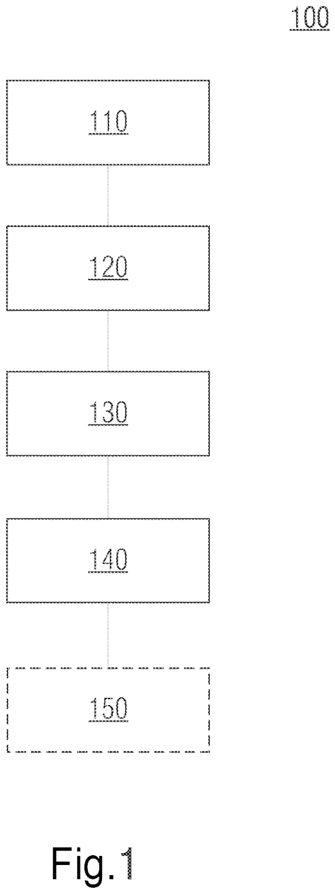

The present invention proposes a fault diagnosis method for a motor. Fig. 1 is a flow chart of a fault diagnosis method 100 according to an embodiment of the present invention; as shown in Fig. 1, the method 100 comprises:
step 110, acquiring a dataset of a motor from a motor driver, and uploading the dataset to a cloud server or an edge device, the dataset comprising multiple motor operating parameters collected at the same point in time.

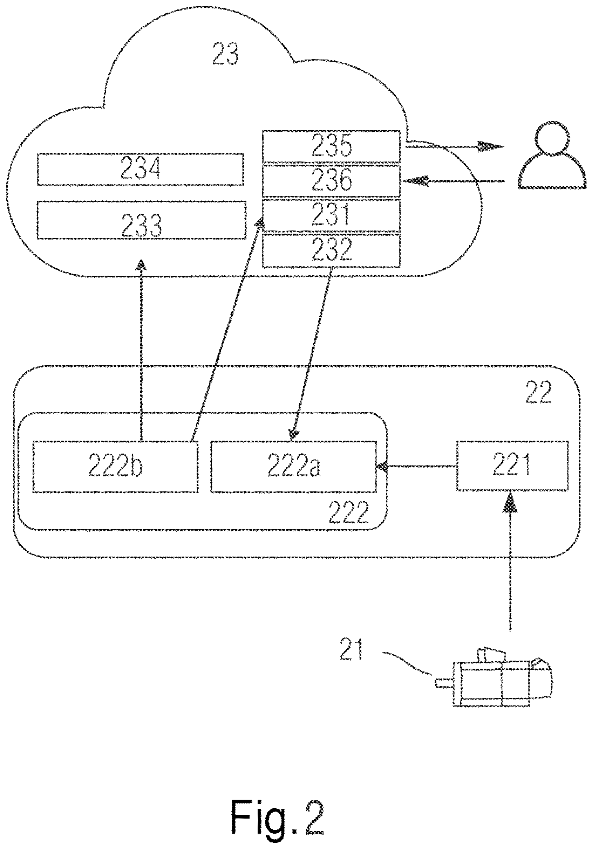

The dataset of the motor is normal in the vast majority of cases, and these data may be collected for use in preliminary judgment of data. Fig. 2 is a schematic drawing of an implementation environment of a fault diagnosis method according to an embodiment of the present invention. As shown in Fig. 2, operating parameters generated by a motor 21 in the course of operation are sent into a data pool 221 of a motor driver 22; the data pool 221 comprises datasets (data pairs) corresponding to different points in time, and multiple datasets are sent to a cloud server 23 by means of a data upload unit 222b in a proxy 222. The datasets comprise multiple motor operating parameters collected at the same point in time; for example, a particular dataset comprises current, rotation speed and torque, etc. at the point in time t. In Fig. 2, the cloud server 23 is taken as an example, but it will be understood that the datasets could also be sent to an edge device to undergo analysis and processing; to simplify description, a cloud server is always used as an example for illustration hereinbelow.

Step 120: training an autoencoder according to the dataset at the cloud server or the edge device, downloading the trained autoencoder to the motor driver, and subjecting the autoencoder to runtime loading at the motor driver.

The autoencoder is an unsupervised neural network model, which can learn hidden features of input data (this is referred to as coding), and at the same time use the new features learned to reconstruct the original input data (this is referred to as decoding). In the case of a trained autoencoder, the disparity between data data (original data) and output data (reconstructed data) should be very small; if data of different features are inputted into a trained autoencoder, the disparity between input data and output data will be very large.

An autoencoder is trained according to datasets at the cloud server or the edge device; since the datasets are normal in the vast majority of cases, the autoencoder produced by training can learn hidden features of normal data, and can thus identify normal datasets and abnormal datasets, i.e. fault datasets, among the datasets. In embodiments of the present invention, the autoencoder may be a convolutional autoencoder. As shown in Fig. 2, the data upload unit 222b sends datasets into an autoencoder training unit 231 of the cloud server 23, and the autoencoder training unit 231 trains the autoencoder according to the datasets. This includes a training process and a verification process: the training process comprises calculating a difference (e.g. root mean square) between input data and output data, and if the root mean square is greater than a threshold, a training parameter (e.g. a number of hidden layers) is adjusted for re-training, until the root mean square between input data and output data is less than a threshold; the verification process comprises using newly uploaded data to verify the autoencoder, and once user confirmation is obtained, the autoencoder training is finished, and the trained autoencoder is obtained. The trained autoencoder is downloaded into an autoencoder runtime 222a of the proxy 222 by means of an autoencoder download unit 232; the autoencoder runtime 222a comprises a running environment of the autoencoder, and once the autoencoder runtime 222a has subjected the autoencoder to runtime loading, the autoencoder can run in the driver.

In some embodiments, the step of training an autoencoder according to the dataset at the cloud server or the edge device comprises: training the autoencoder under each operating condition of the motor, until the difference between input data and reconstructed data of the autoencoder is less than a threshold under all operating conditions. Specifically, operating conditions of the motor may comprise low-load operating conditions, rated operating conditions and overloaded operating conditions. The autoencoder is first trained under a first operating condition until the difference between input data and reconstructed data (output data) is less than a first threshold; training of the autoencoder is continued under a second operating condition, and if the difference between input data and reconstructed data is greater than a second threshold, training parameters are adjusted with reference to training data under the first operating condition and training data under the second operating condition to re-train the autoencoder, until the difference between input data and reconstructed data is less than the second threshold, and so on until the difference between input data and reconstructed data of the autoencoder is less than a threshold under all operating conditions.

Step 130: when autoencoder runtime loading is complete, using the autoencoder to identify fault data in datasets of the motor, and uploading the fault data to the cloud server or the edge device.

When autoencoder runtime loading is complete, the autoencoder can run in the driver, and a new dataset in the data pool is sent to the autoencoder, which calculates the difference between reconstructed data and input data of the new dataset; if the difference is greater than a model threshold, this shows that the dataset is fault data, which is uploaded to the cloud server or the edge device; if the difference is less than a model threshold, this shows that the dataset is normal data, so this dataset will remain at the driver. Thus, normal data and fault data in datasets can be identified by means of an unsupervised neural network model autoencoder. As shown in Fig. 2, once the autoencoder has been loaded by the autoencoder runtime 222a, it can run in the driver, and the autoencoder can identify a new dataset; if the difference between reconstructed data and input data calculated by the autoencoder is greater than a model threshold, this shows that the dataset is fault data, which is uploaded to the cloud server 23 by the data upload unit 222b.

Step 140: training a fault diagnosis model according to the fault data at the cloud server or the edge device, and using the trained fault diagnosis model to subject fault data in motor operation to fault diagnosis.

Fault data can be obtained by means of the autoencoder running in the driver, and this fault data is used to train the fault diagnosis model, which is used to subject fault data, i.e. new fault data, in motor operation to fault diagnosis, thereby realizing a predictive maintenance function of the motor. In embodiments of the present invention, fault diagnosis may be fault classification, i.e. fault types, e.g. electrical energy quality issues (voltage imbalance, harmonic distortion), variable frequency drive issues (voltage overshoot, overloading), mechanical issues (imbalance, loosening, shaft wear), etc. Thus, fault data required by the fault diagnosis model can be obtained by means of the autoencoder, which is an unsupervised-learning neural network model, thus solving the problem of insufficient fault data; in the course of operation, the driver only needs to upload fault data rather than all operating data, so network bandwidth consumption is greatly reduced, and dependence on communication conditions is avoided. Moreover, the training and deployment of the autoencoder and the fault diagnosis model all takes place in the cloud or at the edge, with no need to occupy excessive hardware resources of the driver, thus realizing a lightweight predictive maintenance function of the driver.

In some embodiments, the step of training a fault diagnosis model according to the fault data at the cloud server or the edge device comprises: notifying a user of the fault data, receiving a fault label added to the fault data by the user, and training a fault diagnosis model according to the fault data and the data label. Thus, as a result of the user adding a fault label to the fault data, the data of the fault diagnosis model is more precise, making fault diagnosis more accurate.

In some embodiments, the method further comprises step 150. In step 150, the user is notified of a fault diagnosis result of the fault diagnosis model, user feedback inputted by the user is received; if the user feedback is that the fault diagnosis result is inaccurate, the fault diagnosis model is re-trained, and if the user feedback is that the fault diagnosis result is non-existent, the autoencoder is re-trained. Thus, the autoencoder and fault diagnosis model are adjusted according to user feedback, further improving the accuracy of the autoencoder and the fault diagnosis model, and thus improving the accuracy of fault diagnosis.

A detailed but non-limiting explanation of the process of training the autoencoder, the process of applying the autoencoder, the process of training the fault diagnosis model, and the process of applying the fault diagnosis model, is given below.

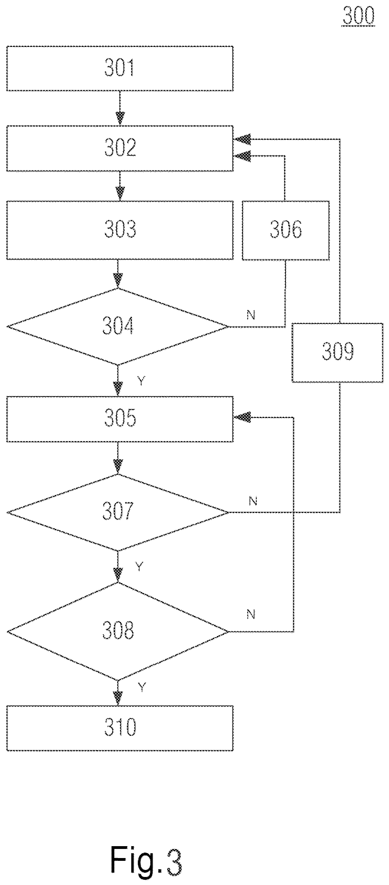

Fig. 3 is a schematic drawing of a training process 300 of an autoencoder according to an embodiment of the present invention; as shown in Fig. 3, the training process 300 comprises:
step 301: the autoencoder training unit 231 of the cloud server 23 acquires a dataset corresponding to a first operating condition;
step 302: the dataset corresponding to the first operating condition is used to train the autoencoder;
step 303: the standard deviation between input data and reconstructed data is calculated;
step 304: judging whether the standard deviation is less than a first threshold, and if so, proceeding to step 305, otherwise proceeding to step 306;
step 305: the autoencoder training unit 231 of the cloud server 23 acquires a dataset corresponding to a second operating condition, and uses the autoencoder to calculate the standard deviation between input data and reconstructed data;
step 306: training parameters of the autoencoder are adjusted;
step 307: judging whether the standard deviation is less than a second threshold, and if so, proceeding to step 308, otherwise proceeding to step 309;
step 308: for confirming whether the training process has ended, and if so, proceeding to step 310, otherwise proceeding to step 305;
step 309: training parameters are adjusted with reference to training data under the first operating condition and training data under the second operating condition;
step 310: end.

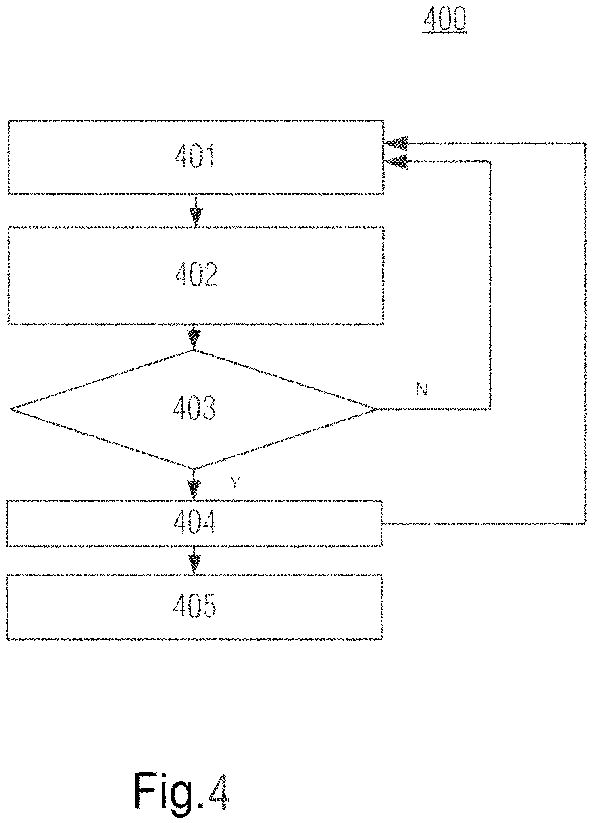

Fig. 4 is a schematic drawing of an application process 400 of an autoencoder according to an embodiment of the present invention; as shown in Fig. 4, the application process 400 of the autoencoder comprises:
step 401: a dataset is sent to the autoencoder;
step 402: the trained autoencoder is used to calculate the root mean square between original data and reconstructed data;
step 403: judging whether the root mean square is greater than a model threshold, and if so, proceeding to step 404, otherwise returning to step 401;
step 404: the dataset is sent to the cloud server 23;
step 405: the cloud server 23 notifies the user and collects a data label added to the dataset by the user.

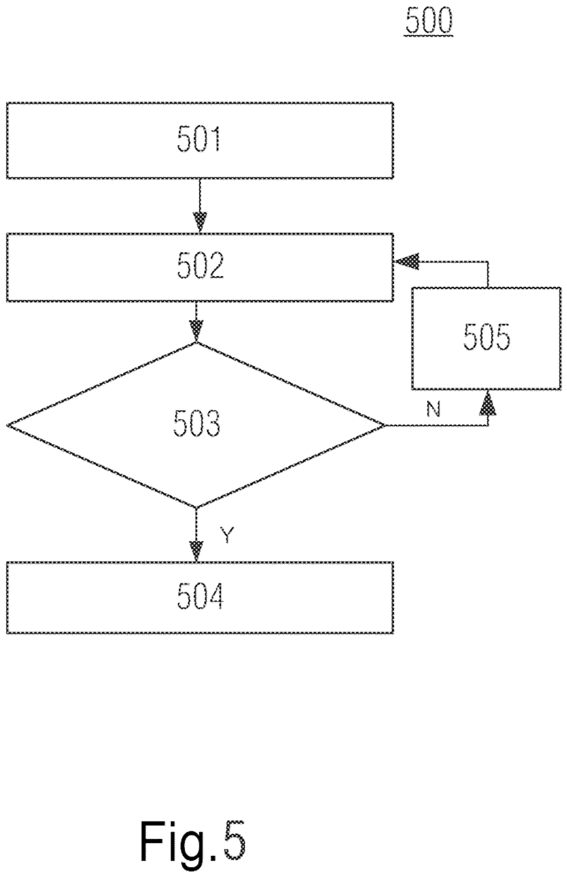

Fig. 5 is a schematic drawing of a training process 500 of a fault diagnosis model according to an embodiment of the present invention; as shown in Fig. 5, the training process 500 of the fault diagnosis model comprises:
step 501: fault data and a label are collected at a cloud server;
step 502: the fault data and the label are used to train the fault diagnosis model;
step 503: judging whether the accuracy of a diagnosis result of the fault diagnosis model is greater than a threshold, and if so, proceeding to step 504, otherwise proceeding to step 505;
step 504: training of the fault diagnosis model ends;
step 505: training parameters are adjusted to re-train the fault diagnosis model.

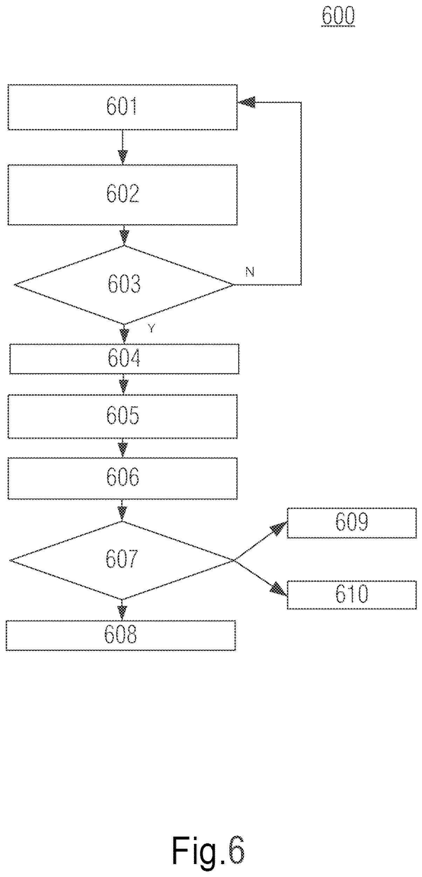

Fig. 6 is a schematic drawing of an application process 600 of a fault diagnosis model according to an embodiment of the present invention; as shown in Fig. 6, the application process 600 of the fault diagnosis model comprises:
step 601: a dataset is sent to an autoencoder of a driver;
step 602: the autoencoder calculates a difference between input data and reconstructed data;
step 603: judging whether the difference is greater than a model threshold, and if so, proceeding to step 604, otherwise returning to step 601;
step 604: fault data is sent to the cloud server;
step 605: the fault diagnosis model is used to subject the fault data to fault diagnosis;
step 606: the user is notified of a fault diagnosis result, and user feedback is collected;
step 607: the user feedback is judged; if the user feedback is that no fault is present, proceed to step 608; if the user feedback is that a fault is present and the fault diagnosis is accurate, proceed to step 609; if the user feedback is that a fault is present but the fault diagnosis is inaccurate, proceed to step 610;
step 608: the autoencoder is re-trained;
step 609: end;
step 610: the fault diagnosis model is re-trained.

Embodiments of the present invention provide a fault diagnosis method for a motor; fault data required by the fault diagnosis model can be obtained by means of the autoencoder, which is an unsupervised-learning neural network model, thus solving the problem of insufficient fault data; in the course of operation, the driver only needs to upload fault data rather than all operating data, so network bandwidth consumption is greatly reduced, and dependence on communication conditions is avoided. Moreover, the training and deployment of the autoencoder and the fault diagnosis model all takes place in the cloud or at the edge, with no need to occupy excessive hardware resources of the driver, thus realizing a lightweight predictive maintenance function of the driver.

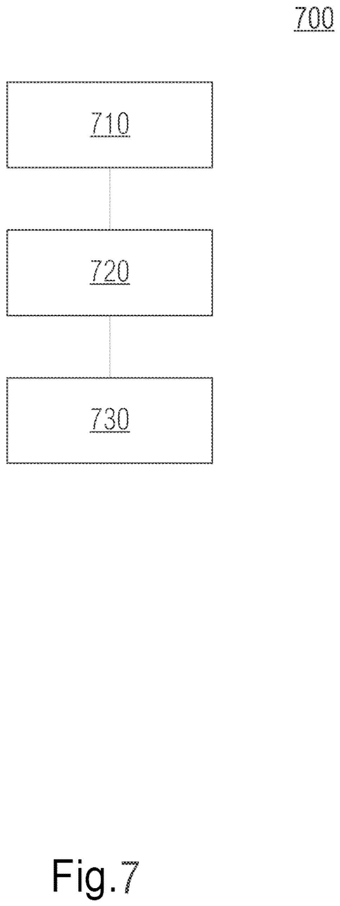

The present invention also proposes a fault diagnosis method for a motor, the fault diagnosis method being performed in a motor driver. Fig. 7 is a flow chart of a fault diagnosis method 700 according to another embodiment of the present invention; as shown in Fig. 7, the method 700 comprises:
step 710, acquiring a dataset of the motor, and uploading the dataset to a cloud server or an edge device, the dataset comprising multiple motor operating parameters collected at the same point in time;
step 720, downloading an autoencoder from the cloud server or the edge device, and subjecting the autoencoder to runtime loading at the driver, the autoencoder being obtained by training according to datasets by the cloud server or the edge device;
step 730, when autoencoder runtime loading is complete, using the autoencoder to identify fault data in datasets of the motor, and uploading the fault data to the cloud server or the edge device, the fault data being used to train a fault diagnosis model according to the fault data at the cloud server or the edge device, and using the trained fault diagnosis model to subject fault data in motor operation to fault diagnosis.

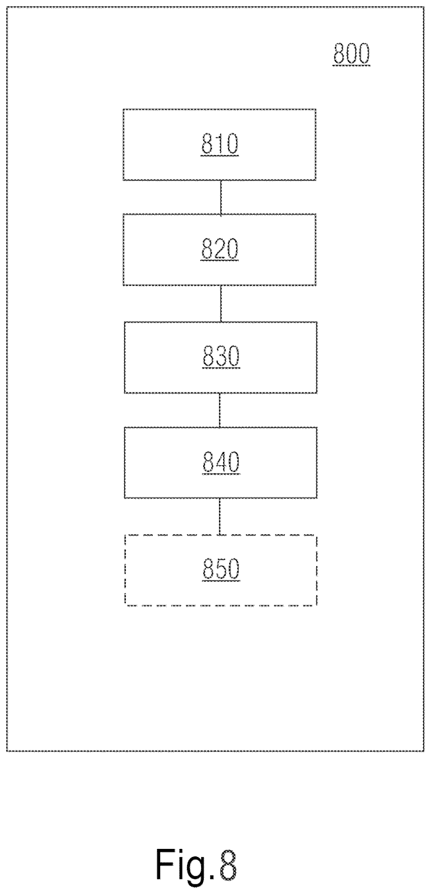

The present invention also proposes a fault diagnosis apparatus for a motor. Fig. 8 is a schematic drawing of a fault diagnosis apparatus according to an embodiment of the present invention; as shown in Fig. 8, the apparatus 800 comprises:
a first data processing module 810, for acquiring a dataset of the motor from a motor driver, and uploading the dataset to a cloud server or an edge device, the dataset comprising multiple motor operating parameters collected at the same point in time;
a training module 820, for training an autoencoder according to datasets at the cloud server or the edge device, downloading the trained autoencoder to the motor driver, and subjecting the autoencoder to runtime loading at the motor driver;
a second data processing module 830, for using the autoencoder to identify fault data in datasets of the motor when autoencoder runtime loading is complete, and uploading the fault data to the cloud server or the edge device;
a fault diagnosis module 840, for training a fault diagnosis model according to fault data at the cloud server or the edge device, and using the trained fault diagnosis model to subject fault data in motor operation to fault diagnosis.

In some embodiments, the training module 820 training an autoencoder according to datasets at the cloud server or the edge device comprises: training an autoencoder under each operating condition of the motor, until a difference between input data and reconstructed data of the autoencoder is less than a threshold under all operating conditions.

In some embodiments, the fault diagnosis module 840 training a fault diagnosis model according to fault data at the cloud server or the edge device comprises: notifying a user of fault data, receiving a fault label added to the fault data by the user, and training a fault diagnosis model according to the fault data and the data label.

In some embodiments, the apparatus further comprises a user feedback module 850, the user feedback module 850 notifying the user of a fault diagnosis result of the fault diagnosis model, and receiving user feedback inputted by the user, wherein the fault diagnosis model is re-trained if the user feedback is that the fault diagnosis result is inaccurate, and the autoencoder is re-trained if the user feedback is that the fault diagnosis result is non-existent.

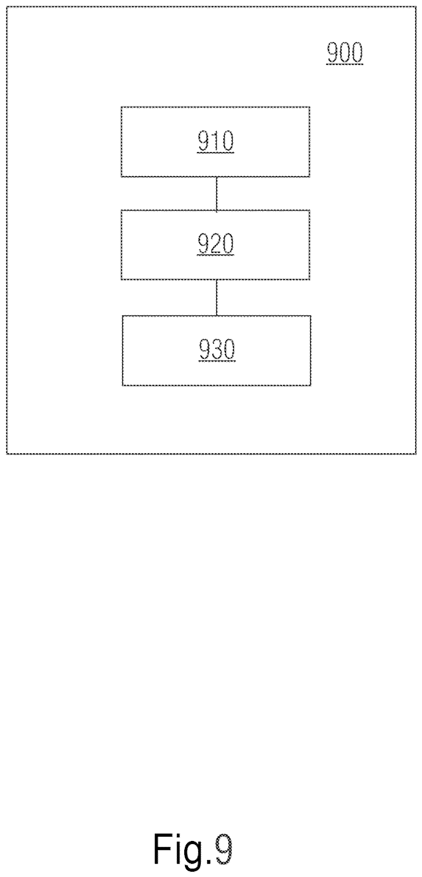

The present invention further proposes a fault diagnosis apparatus for a motor, the fault diagnosis apparatus being implemented in a motor driver. Fig. 9 is a schematic drawing of a fault diagnosis apparatus 900 according to another embodiment of the present invention, the apparatus 900 comprising:
a first data upload module 910, for acquiring a dataset of a motor, and uploading the dataset to a cloud server or an edge device, the dataset comprising multiple motor operating parameters collected at the same point in time;
a download module 920, for downloading an autoencoder from the cloud server or the edge device, and subjecting the autoencoder to runtime loading at the driver, the autoencoder being obtained by training according to datasets by the cloud server or the edge device;
a second data upload module 930, for using the autoencoder to identify fault data in datasets of the motor when autoencoder runtime loading is complete, and uploading the fault data to the cloud server or the edge device, the fault data being used to train a fault diagnosis model according to the fault data at the cloud server or the edge device, and using the trained fault diagnosis model to subject fault data in motor operation to fault diagnosis.

The present invention further proposes a motor driver, the motor driver being configured to perform the fault diagnosis method 700 described above.

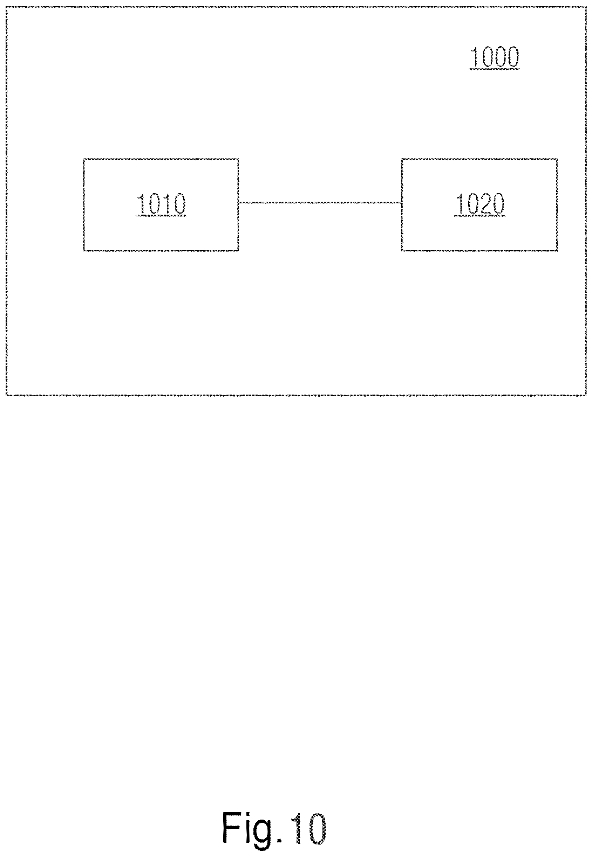

The present invention further proposes an electronic device 1000. Fig. 10 is a schematic drawing of an electronic device 1000 according to an embodiment of the present invention. As shown in Fig. 10, the electronic device 1000 comprises a processor 1010 and a memory 1020, with instructions stored in storage of the memory 1020, wherein the instructions, when executed by the processor 1010, realize the method 100 described above.

The present invention further proposes a computer-readable storage medium, having stored thereon computer instructions which, when run, perform the methods 100 and 700 described above.

The present invention further proposes a computer program product, comprising a computer program which, when executed by a processor, implements the methods 100 and 700 described above.

Some aspects of the method and apparatus of the present invention may be executed by hardware alone, by software (including firmware, resident software, microcode, etc.) alone, or by a combination of hardware and software. The above hardware and software may all be referred to as "data blocks", "modules", "engines", "units", "components" or "systems". The processor may be one or more application specific integrated circuit (ASIC), digital signal processor (DSP), digital signal processing device (DAPD), programmable logic device (PLC), field programmable gate array (FPGA), processor, controller, microcontroller, microprocessor or a combination thereof. In addition, each aspect of the present invention might be embodied as a computer product located in one or more computer-readable medium, the product comprising computer-readable program code. For example, the computer-readable media may include, but are not limited to, magnetic storage devices (e.g. hard disks, floppy disks, magnetic tapes...), optical discs (e.g. compact discs (CD), digital versatile discs (DVD)...), smart cards and flash memory devices (e.g. cards, sticks, key drivers...).

Flow charts are used herein to illustrate the operations performed in the method according to embodiments of the present application. It should be understood that the above operations are not necessarily performed precisely in order. Conversely, various steps may be processed in reverse order or simultaneously. Furthermore, other operations might be added to these processes, or one or more operation steps might be removed from these processes.

It should be understood that, although the description herein is based on embodiments, it is by no means the case that each embodiment comprises only one independent technical solution; this manner of presentation is adopted herein purely for clarity, and those skilled in the art should consider this specification in its entirety. The technical solutions in different embodiments may also be suitably combined to form other embodiments understandable to those skilled in the art.

The above are merely specific schematic embodiments of the present invention, which are not intended to limit the scope thereof. All equivalent changes, modifications and combinations made by any person skilled in the art without departing from the concept and principles of the present invention shall be included in the scope of protection thereof.

## Claims

1. A fault diagnosis method (100) for a motor, **characterized in that** the method (100) comprises:
acquiring a dataset of the motor from a motor driver, and uploading the dataset to a cloud server or an edge device, the dataset comprising multiple motor operating parameters collected at the same point in time (110);
training an autoencoder according to the dataset at the cloud server or the edge device, downloading the trained autoencoder to the motor driver, and subjecting the autoencoder to runtime loading at the motor driver (120);
when the autoencoder runtime loading is complete, using the autoencoder to identify fault data in datasets of the motor, and uploading the fault data to the cloud server or the edge device (130);
training a fault diagnosis model according to the fault data at the cloud server or the edge device, and using the trained fault diagnosis model to subject fault data in motor operation to fault diagnosis (140).

2. The fault diagnosis method (100) as claimed in claim 1, **characterized in that** the step of training an autoencoder according to the dataset at the cloud server or the edge device comprises: training the autoencoder under each operating condition of the motor, until a difference between input data and reconstructed data of the autoencoder is less than a threshold under all operating conditions.

3. The fault diagnosis method (100) as claimed in claim 1 or 2, **characterized in that** the step of training a fault diagnosis model according to the fault data at the cloud server or the edge device comprises: notifying a user of the fault data, receiving a fault label added to the fault data by the user, and training the fault diagnosis model according to the fault data and the data label.

4. The fault diagnosis method (100) as claimed in any one of claims 1 - 3, **characterized in that** the method (100) further comprises: notifying a user of a fault diagnosis result of the fault diagnosis model, receiving user feedback inputted by the user, re-training the fault diagnosis model if the user feedback is that the fault diagnosis result is inaccurate, and re-training the autoencoder if the user feedback is that the fault diagnosis result is non-existent (150).

5. A fault diagnosis method (700) for a motor, the fault diagnosis method being performed in a motor driver, **characterized in that** the method (700) comprises:
acquiring a dataset of the motor, and uploading the dataset to a cloud server or an edge device, the dataset comprising multiple motor operating parameters collected at the same point in time (710);
downloading an autoencoder from the cloud server or the edge device, and subjecting the autoencoder to runtime loading at the driver, the autoencoder being obtained by training according to the dataset by the cloud server or the edge device (720);
when the autoencoder runtime loading is complete, using the autoencoder to identify fault data in datasets of the motor, and uploading the fault data to the cloud server or the edge device, the fault data being used to train a fault diagnosis model according to the fault data at the cloud server or the edge device, and using the trained fault diagnosis model to subject fault data in motor operation to fault diagnosis (730).

6. A fault diagnosis apparatus (800) for a motor, **characterized in that** the apparatus (800) comprises:
a first data processing module (810), for acquiring a dataset of the motor from a motor driver, and uploading the dataset to a cloud server or an edge device, the dataset comprising multiple motor operating parameters collected at the same point in time;
a training module (820), for training an autoencoder according to the dataset at the cloud server or the edge device, downloading the trained autoencoder to the motor driver, and subjecting the autoencoder to runtime loading at the motor driver;
a second data processing module (830), for using the autoencoder to identify fault data in datasets of the motor when the autoencoder runtime loading is complete, and uploading the fault data to the cloud server or the edge device;
a fault diagnosis module (840), for training a fault diagnosis model according to the fault data at the cloud server or the edge device, and using the trained fault diagnosis model to subject fault data in motor operation to fault diagnosis.

7. The fault diagnosis apparatus (800) as claimed in claim 6, **characterized in that** the training module (820) training an autoencoder according to the dataset at the cloud server or the edge device comprises: training the autoencoder under each operating condition of the motor, until a difference between input data and reconstructed data of the autoencoder is less than a threshold under all operating conditions.

8. The fault diagnosis apparatus (800) as claimed in claim 6 or 7, **characterized in that** the fault diagnosis module (840) training a fault diagnosis model according to the fault data at the cloud server or the edge device comprises: notifying a user of the fault data, receiving a fault label added to the fault data by the user, and training the fault diagnosis model according to the fault data and the data label.

9. The fault diagnosis apparatus (800) as claimed in any one of claims 6 - 8, **characterized in that** the apparatus (800) further comprises a user feedback module (850), the user feedback module (850) notifying a user of a fault diagnosis result of the fault diagnosis model, and receiving user feedback inputted by the user, wherein the fault diagnosis model is re-trained if the user feedback is that the fault diagnosis result is inaccurate, and the autoencoder is re-trained if the user feedback is that the fault diagnosis result is non-existent.

10. A fault diagnosis apparatus (900) for a motor, the fault diagnosis apparatus (900) being implemented in a motor driver, **characterized in that** the apparatus (900) comprises:
a first data upload module (910), for acquiring a dataset of the motor, and uploading the dataset to a cloud server or an edge device, the dataset comprising multiple motor operating parameters collected at the same point in time;
a download module (920), for downloading an autoencoder from the cloud server or the edge device, and subjecting the autoencoder to runtime loading at the driver, the autoencoder being obtained by training according to the dataset by the cloud server or the edge device;
a second data upload module (930), for using the autoencoder to identify fault data in datasets of the motor when the autoencoder runtime loading is complete, and uploading the fault data to the cloud server or the edge device, the fault data being used to train a fault diagnosis model according to the fault data at the cloud server or the edge device, and using the trained fault diagnosis model to subject fault data in motor operation to fault diagnosis.

11. A motor driver, **characterized in that** the motor driver is configured to perform the fault diagnosis method as claimed in claim 5.

12. An electronic device (1000), comprising a processor (1010), a memory (1020), and instructions stored in the memory (1020), wherein the instructions, when executed by the processor (1010), realize the method (100, 700) as claimed in any one of claims 1 - 5.

13. A computer-readable storage medium, having stored thereon computer instructions which, when run, perform the method (100, 700) as claimed in any one of claims 1 - 5.

14. A computer program product, **characterized by** comprising a computer program which, when executed by a processor, implements the method (100, 700) as claimed in any one of claims 1 - 5.
